(19) Europäisches Patentamt
European Patent Office
Office européen des brevets

(11) **EP 1 704 452 B1**

(12) **EUROPÄISCHE PATENTSCHRIFT**

(45) Veröffentlichungstag und Bekanntmachung des Hinweises auf die Patenterteilung:
**11.03.2009 Patentblatt 2009/11**

(21) Anmeldenummer: **05700533.2**

(22) Anmeldetag: **11.01.2005**

(51) Int Cl.:
*G05F 3/26* (2006.01)   *H03F 3/45* (2006.01)
*H03F 1/30* (2006.01)

(86) Internationale Anmeldenummer:
**PCT/DE2005/000020**

(87) Internationale Veröffentlichungsnummer:
**WO 2005/069097 (28.07.2005 Gazette 2005/30)**

(54) **TRANSISTORANORDNUNG MIT TEMPERATURKOMPENSATION UND VERFAHREN ZUR TEMPERATURKOMPENSATION**

TRANSISTOR ARRANGEMENT WITH TEMPERATURE COMPENSATION AND METHOD FOR TEMPERATURE COMPENSATION

SYSTEME TRANSISTOR A COMPENSATION DE TEMPERATURE ET PROCEDE DE COMPENSATION DE TEMPERATURE

(84) Benannte Vertragsstaaten:
**DE FR GB**

(30) Priorität: **14.01.2004 DE 102004002007**

(43) Veröffentlichungstag der Anmeldung:
**27.09.2006 Patentblatt 2006/39**

(73) Patentinhaber: **Infineon Technologies AG**
**81669 München (DE)**

(72) Erfinder: **OEHM, Jürgen**
**40885 Ratingen (DE)**

(74) Vertreter: **Epping - Hermann - Fischer**
**Patentanwaltsgesellschaft mbH**
**Ridlerstraße 55**
**80339 München (DE)**

(56) Entgegenhaltungen:
EP-A- 0 998 022     US-A- 5 440 305
US-B1- 6 396 339     US-B1- 6 674 377

• **RAMIREZ-ANGULO J ED - INSTITUTE OF ELECTRICAL AND ELECTRONICS ENGINEERS: "Digitally trimmable MOS-current mirrors for high precision applications" PROCEEDINGS OF THE INTERNATIONAL SYMPOSIUM ON CIRCUITS AND SYSTEMS. (ISCS). CHICAGO, MAY 3 - 6, 1993, NEW YORK, IEEE, US, Bd. VOL. 2, 3. Mai 1993 (1993-05-03), Seiten 974-977, XP010115263 ISBN: 0-7803-1281-3**

EP 1 704 452 B1

**Beschreibung**

Die vorliegende Erfindung betrifft eine Transistoranordnung, bei der wesentliche Transistoreigenschaften unabhängig von der Betriebstemperatur sind, die Verwendung der Transistoranordnung in einem integrierten Halbleiterschaltkreis und ein Verfahren zur Temperaturkompensation.

Wegen der heute in moderner Metall-Oxid-Halbleiter, MOS-Schaltungstechnik realisierbaren Strukturgrößen von kleiner 0,3 $\mu$m ist es möglich geworden, Sendeempfänger auch für Signalfrequenzen im GHz-Bereich zu realisieren. Mit dem fortschreitenden Einzug drahtloser Kommunikation in alle Bereiche des täglichen Lebens steigt gleichzeitig die Nachfrage nach immer höheren Datenübertragungsraten. Da die für die freie Drahtloskommunikation nutzbaren Frequenzbänder im unteren GHz-Bereich beschränkt sind, wird man zukünftig höhere Modulationsverfahren einsetzen mit dem Ziel, trotz dieser Beschränkung höhere Datenraten übertragen zu können. Die verfügbaren Kanalbandbreiten sollen dabei nicht vergrößert werden müssen. Höhere Modulationsverfahren wie z.B. 4QPSK, Quadratur-Phasenumtastung, erfordern für einige analoge Funktionsgruppen in den Sendeempfängern neue schaltungstechnische Lösungen, welche eine lineare oder zumindest linearere Signalverarbeitung ermöglichen. Dabei sollen die bisher erreichten Eigenschaften derartiger Schaltungen sowie deren Vorteile zumindest erhalten bleiben. Zudem soll eine Kompatibilität zu den derzeit vorhandenen Mobilfunkstandards, welche beispielsweise auf GFSK, Gauß'scher Frequenzumtastung beruhen, möglich sein.

Es ist also wünschenswert, in MOS-Schaltungen grundlegende elektrische Eigenschaften wie Stromverbrauch, Dynamikbereich, Verstärkung oder Transitfrequenz über den technisch relevanten Temperaturbereich von ca. -40˚ bis +140˚ im wesentlichen konstant zu halten. Dabei ist es ein Ziel, nicht nur jeweils eine der Kenngrößen integrierter Schaltungen, sondern alle genannten Kenngrößen gleichzeitig über die Temperatur konstant zu halten.

Grundsätzlich sind MOS-Schaltungen für eine analoge lineare Signalverarbeitung als solche bekannt. Beispielsweise in der Druckschrift M. Gräfe, J. Oehm, K. Schumacher: "A Wide Range dB-Linear Variable Gain CMOS Amplifier", Proceedings ESSCIRC '97, September 1997", ist eine sogenannte Square-Law-Schaltung angegeben, mit der analoge Spannungssignale linear verarbeitet werden können.

Derartige Schaltungen haben jedoch die Eigenschaft, daß Schaltungskenngrößen wie Stromverbrauch, Dynamikbereich, Verstärkung und Transitfrequenz über den technisch relevanten Temperaturbereich nicht alle gleichzeitig konstant gehalten werden können, sondern daß die Temperatur-Unabhängigkeit jeweils nur für einige dieser Kenngrößen erzielt werden kann.

Die Konstanz der Steilheit beispielsweise eines Transistorverstärkers kann dadurch verbessert werden, daß der Strom durch den Transistor temperaturgesteuert ist. Über den genannten, relevanten Temperaturbereich ist jedoch ungefähr eine Verdopplung des Stromes nötig, um konstante Verhältnisse insbesondere bei hohen Temperaturen noch gewährleisten zu können. Diese hohen Stromverbräuche sind jedoch unerwünscht.

Das Dokument US 6,674,377 B1 betrifft einen Schaltkreis, eine Vorrichtung und ein Verfahren für verbesserte Stromverteilung von Ausgangstreibern zur genaueren Kalibrierung.

Aufgabe der vorliegenden Erfindung ist es, eine Transistoranordnung mit Temperaturkompensation zu schaffen, die es ermöglicht, gleichzeitig elektrische Kenngrößen wie Stromverbrauch, Dynamikbereich, Verstärkung und Transitfrequenz über den technisch relevanten Temperaturbereich weitgehend konstant zu halten.

Erfindungsgemäß wird die Aufgabe bezüglich der Anordnung gelöst durch eine Transistoranordnung mit Temperaturkompensation, aufweisend die Merkmale des Patentanspruchs 1.

Bezüglich des Verfahrens wird die Aufgabe gelöst durch ein Verfahren zur Temperaturkompensation mit den Schritten des Patentanspruchs 13.

Es entspricht dem vorgeschlagenen Prinzip, daß die Temperaturkompensation der Transistorkenngrößen nicht über eine Temperatursteuerung des Stroms durch den Transistor erfolgt, sondern daß vielmehr in Abhängigkeit von der Temperatur zumindest ein Geometrieparameter des Transistors verändert wird.

Die Ansteuerung des zumindest einen Geometrieparameters und dessen Einstellung erfolgt dabei mit Vorteil derart, daß eine verschwindende oder möglichst geringe Temperaturabhängigkeit von Transistorkenngrößen wie Stromverbrauch, Dynamikbereich, Verstärkung und Transitfrequenz gegeben ist.

Dadurch ergibt sich der wesentliche Vorteil, daß bei hohen Temperaturen keine wesentliche Erhöhung des Strombedarfs der Schaltung gegeben ist.

Die Temperatur wird mit einem Mittel zur Temperaturmessung erfaßt. Dafür ist jedoch nicht notwendig, einen eigens zu diesem Zweck dienenden Sensor zu integrieren, sondern vielmehr können die temperaturabhängigen Eigenschaften von teilweise ohnehin vorhandenen Bauteilen ausgenutzt werden.

Wenn der Transistor bevorzugt ein unipolarer Transistor ist, also beispielsweise ein Metal Oxide Semiconductor, MOS-Transistor, so umfaßt der zumindest eine Geometrieparameter bevorzugt die Kanallänge und/oder die Kanalweite des Transistors.

Dabei wird in Abhängigkeit von der mit dem Mittel zur Temperaturmessung erfaßten Temperatur durch die Steuereinheit die Kanallänge und/oder die Kanalweite des Transistors so verändert, daß die genannten elektrischen Kenngrößen des Transistors, wie Stromverbrauch, Steilheit und Transitfrequenz, konstant oder weitgehend konstant bleiben.

Die Kanallänge und/oder die Kanalweite des Transistors kann bevorzugt in diskreten Schritten verstellbar sein.

Die Kanalweite und/oder die Kanallänge kann mit Vorteil dadurch verändert werden, daß der Transistor in mehrere parallel und/oder seriell miteinander verschaltete Teiltransistoren aufgeteilt ist, welche jeweils unabhängig voneinander und einzeln in Abhängigkeit von dem temperaturabhängigen Signal zu- und abschaltbar sind. Demnach wird die Kanalweite und/oder die Kanallänge in diskreten Schritten verändert. Zu- und abschaltbare Parallelschaltungen und/oder Serienschaltungen von Einzeltransistoren sind in integrierter Schaltungstechnik besonders einfach und präzise herstellbar.

Die Steuereinheit ist mit einem Vergleicher gekoppelt, der das temperaturabhängige Signal, welches das Mittel zur Temperaturmessung liefert, mit einem temperaturunabhängigen Signal als Referenzgröße vergleicht und in Abhängigkeit vom Vergleichsergebnis eine Einstellung des zumindest einen Geometrieparameters des Transistors bewirkt.

Alternativ könnte eine Zuordnungstabelle vorgesehen sein, mit der dem temperaturabhängigen Signal ein Steuerwort zugeordnet wird zur Einstellung des zumindest einen Geometrieparameters des Transistors. Eine solche Tabelle wird auch als Look-Up-Table bezeichnet.

Zur Erzeugung des temperaturunabhängigen Signals ist bevorzugt eine Bandgap-Schaltung vorgesehen.

Das Mittel zur Temperaturmessung umfaßt bevorzugt einen Transistor. Dadurch ist es möglich, die bezüglich der Temperatur zu kompensierende Transistoranordnung so in Abhängigkeit von den Temperatureigenschaften eines Transistors anzusteuern, so daß eine hohe Genauigkeit der Kompensation der Temperatureigenschaften der Transistoranordnung gewährleistet ist.

Das Mittel zur Temperaturmessung kann auch beispielsweise eine Diodenstrecke oder ein beliebiges anderes temperaturabhängiges Mittel sein.

Außerdem kann mit Vorteil ein Regelkreis dadurch gebildet sein, daß ein Transistor mit verstellbarem Geometrieparameter in einen Rückführungszweig des Vergleichers geschaltet ist.

Das Zu- und Abschalten der parallel und/oder seriell verschalteten Teiltransistoren, mit denen die Kanalweite und/oder die Kanallänge des Transistors verändert werden kann, ist bevorzugt dadurch ermöglicht, daß jedem Teiltransistor ein Schalttransistor zugeordnet ist.

Zur Verstellung der Kanalweite bilden bevorzugt jeder Teiltransistor und jeder Schalttransistor miteinander eine Serienschaltung. Die Serienschaltungen umfassend je einen Teiltransistor und einen Schalttransistor sind miteinander parallel verschaltet. Die Schalttransistoren haben dabei bevorzugt einen Steuereingang, der mit der Steuereinheit zu deren Zu- und Abschaltung unabhängig voneinander gekoppelt ist.

Demnach kann die gewünschte Anzahl der Teiltransistoren parallel miteinander verschaltet werden, so daß die Kanalweite der gesamten Transistoranordnung des Transistors, dessen Eigenschaften über die Temperatur zu kompensieren sind, einstellbar ist.

Alternativ kann anstelle des Schalttransistors in Serie zum Teiltransistor auch jeweils ein anderes Schaltmittel zum Zu- und Abschalten der Teiltransistoren vorgesehen sein.

Insbesondere sind die Teiltransistoren bevorzugt als Metall-Isolator-Halbleiter-Transistoren ausgebildet. Der dem Teiltransistor zugeordnete Schalttransistor kann dabei im Source-Pfad und/oder im Drain-Pfad des Teiltransistors angeordnet sein.

Bevorzugt ist der Schalttransistor jeweils am Drain-Anschluß des zugeordneten Teiltransistors angeschlossen. Die Anordnung des Schalttransistors im Drain-Pfad des Teiltransistors hat den Vorteil, daß aufgrund der Verschaltung Spannungsabfälle über dem Schalter praktisch ohne Auswirkungen auf die Verstärkungseigenschaften der Stufe sind.

Bevorzugt ist jedem einzeln zu- und abschaltbaren Teiltransistor jeweils eine Kaskode-Stufe zugeordnet. Dabei kann der Kaskode-Transistor mit Vorteil gleichzeitig als Schalter dienen. Dies ist insbesondere dann vorteilhaft anwendbar, wenn der Transistor bezüglich seiner elektrisch wirksamen Kanalweite elektronisch einstellbar ist.

Weitere Einzelheiten und Ausgestaltungen des vorgeschlagenen Prinzips sind Gegenstand der Unteransprüche.

Die Erfindung wird nachfolgend an mehreren Ausführungsbeispielen anhand von Zeichnungen näher erläutert.

Es zeigen:

Figur 1    ein erstes Ausführungsbeispiel einer Transistoranordnung mit Temperaturkompensation gemäß dem vorgeschlagenen Prinzip,

Figur 2    ein zweites Ausführungsbeispiel einer Transistoranordnung mit Temperaturkompensation gemäß dem vorgeschlagenen Prinzip,

Figur 3    ein Beispiel einer Transistoranordnung mit Temperaturkompensation bei einer Differenzstufe,

Figur 4    ein Ausführungsbeispiel einer Schaltungsanordnung zur Referenzstromerzeugung zur Anwendung in den Schaltungen Figur 1 oder 2,

Figur 5a    ein Ausführungsbeispiel eines Transistors mit digital einstellbarer Kanalweite,

Figur 5b    ein Ersatzschaltbild der Schaltung von Figur 5a,

Figur 6    ein Ausführungsbeispiel eines Transistors mit digital einstellbarer Kanalweite schaltbar im Source-Pfad sowie dessen Ersatzschaltbild,

Figur 7    ein Ausführungsbeispiel eines Transistors mit digital einstellbarer Kanalweite schaltbar im Drain-Pfad sowie dessen Ersatzschaltbild,

Figur 8    anhand eines Schaubildes den sogenannten Square-Law-Dynamikbereich,

Figur 9    ein Ausführungsbeispiel eines Transistors mit digital einstellbarer Kanalweite und Kaskode-Stufe sowie dessen Ersatzschaltbild,

Figur 10    ein Ausführungsbeispiel eines Transistors mit digital einstellbarer Kanallänge sowie dessen Ersatzschaltbild,

Figur 11    ein Schaubild zur Veranschaulichung der Square-Law-Technik und

Figur 12    ein Beispiel einer Transistoranordnung mit Temperaturkompensation.

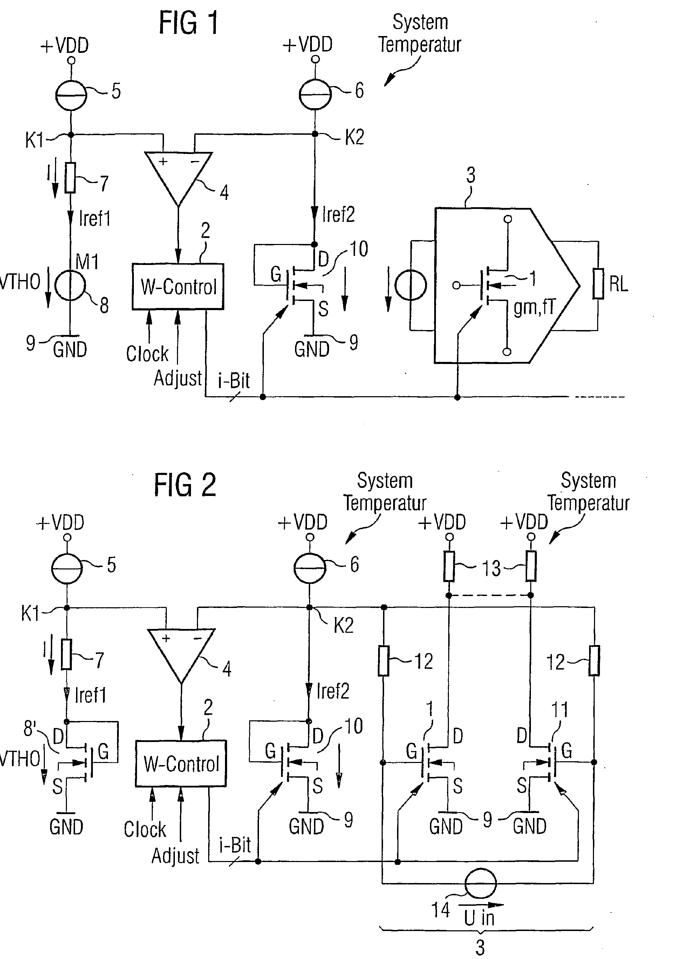

Figur 1 zeigt anhand eines Schaltplans ein Ausführungsbeispiel einer Transistoranordnung mit Temperaturkompensation. Es ist ein Verstärker 3 mit Abgleicheinrichtung zur Temperaturkompensation vorgesehen. Ein erster Transistor 1 hat einen Steuereingang und eine gesteuerte Strecke. Der Transistor 1 ist als MOS-Feldeffekttransistor ausgebildet. Der Transistor 1 hat einen einstellbaren Geometrieparameter, nämlich die Weite des Kanals. Eine Steuereinheit 2 gibt ein mehrere Bit breites, digitales Steuerwort an einem Ausgang ab, der mit dem Transistor 1 gekoppelt ist zur Einstellung der Kanalweite. Der Transistor 1 ist in einem Verstärker 3 angeordnet. Der Verstärker 3 kann auch mehrere Transistoren haben, welche jeweils den gleichen Aufbau wie der Transistor 1 und die gleiche Ansteuerung ihrer Kanalweite besitzen. An einen Eingang der Steuereinheit 2 ist ein Komparator 4 angeschlossen, der zwei Eingänge hat. Jeder Eingang des Komparators 4 ist mit einem Schaltungsknoten K1, K2 verbunden. Jeder Schaltungsknoten K1, K2 ist über je eine zugeordnete Stromquelle 5, 6 mit einem Versorgungspotentialanschluß VDD verbunden. Der erste Schaltungsknoten K1 ist über einen Widerstand 7 und eine Spannungsquelle 8 gegen Bezugspotentialanschluß 9 geschaltet. Der zweite Schaltungsknoten K2 ist über einen Transistor 10 gegen Bezugspotentialanschluß 9 geschaltet. Der Transistor 10 ist als MOS-Transistor ausgeführt und als Diode verschaltet. Die Spannungsquelle 8 stellt ein temperaturabhängiges Signal bereit, nämlich die MOS-Schwellspannung VTH0. Das von der Spannungsquelle 8 bereitgestellte Signal dient als Führungsgröße und hat einen Temperaturgang, der sich herausrechnet. Die Diode 10 ist bezüglich der effektiven Gate-Spannung dadurch temperaturstabil, daß der die Transistordiode bildende Transistor ebenfalls wie der Transistor 1 eine einstellbare Kanalweite aufweist. Hierfür ist der Ausgang der Steuereinheit 2 ebenfalls mit dem Transistor 10 gekoppelt. Über dem Widerstand 7 fällt eine Spannung ab, die sich aus dem Produkt aus dem Widerstandswert des Widerstands 7 und dem ihn durchfließenden Strom, einem Referenzstrom berechnet. Dieser Referenzstrom kann beispielsweise in der Art aus der Bandgap-Schaltung gewonnen werden, daß der Spannungsabfall als Teilwert der Bandgap-Spannung erscheint und ebenfalls temperaturstabil ist.

Vorliegend ist mit dem Vergleicher 4, der Steuereinheit 2 und der Transistordiode 10 ein Regelkreis gebildet. Dabei wird die Kanalweite des Transistors 10 beeinflußt. Ziel des Regelung ist, daß die Spannung am Schaltungsknoten K1 und die Spannung am Schaltungsknoten K2 ungefähr übereinstimmen.

Der Vergleicher 4 vergleicht zwei Potentiale an den Schaltungsknoten K1, K2, die aufgrund der Referenzströme IREF1, IREF2 entstehen. Für die Spannung UK1 am ersten Schaltungsknoten K1 gilt:

$$UK1 = VTH0 + IREF1 \cdot R1,$$

wobei R1 den Wert des Widerstands 7 repräsentiert.

Für die Spannung UK2 am zweiten Schaltungsknoten K2 gilt:

$$UK2 = VTH0 + Vgeff,$$

wobei Vgeff die effektive Gatespannung repräsentiert.

Aus dem Vergleich der Potentiale UK1, UK2 ergibt sich am Ausgang des Komparators eine logische Null, wenn gilt: UK1 < UK2. Die Konvention kann auch umgekehrt ausgeführt sein. Die Steuereinheit 2 umfaßt eine Logikeinrichtung, welche gesteuert durch den logischen Zustand am Ausgang des Komparators ein Steuersignal mit der Wortbreite i erzeugt. Die Logik der Steuereinheit 2 wird entweder durch einen internen oder externen Takt gesteuert. Ein interner Takt kann mit Vorteil aus dem Signal am Komparatorausgang abgeleitet werden. Ein Adjust-Signal der Steuereinheit 2 speichert den aktuellen Zustand des digitalen Steuerwortes mit der Wortbreite i. Solange das Adjust-Signal eine Veränderung des digitalen Steuerwortes erlaubt, wird es in dem Sinn verändert, daß am Ende eines Abgleichzyklusses der Ausgang des Komparators nach jeder Veränderung des digitalen Wortes zwischen logischer Null und logischer Eins wechselt. Die Veränderung des digitalen Wortes ist dann nur noch von der Art, daß die kleinstmögliche Veränderung in den digital gesteuerten MOS-Geometrien von Transistor 1 und Transistor 10 stattfindet. Die Spannungen an den Knoten K1 und K2 sind dann näherungsweise identisch. Der maximal mögliche Unterschied zwischen den Spannungsknoten K1 und K2 ist dann bestimmt durch die kleinstmögliche Veränderung in den digital gesteuerten MOS-Geometrien von Transistor 10. Für die Spannung UK2 gilt nach dem Abgleich:

$$UK2 \approx VTH0 + IREF1 \cdot R1.$$

Das digitale Steuerwort der Wortbreite i liegt gleichzeitig auch am Verstärker 3 an, so daß alle geometriegesteuerten MOS-Transistoren 1 im Verstärker 3 ebenfalls gemäß dem Ergebnis des Abgleichsvorgangs programmiert sind. Ist in allen geometriegesteuerten MOS-Transistoren ein von der Temperatur unabhängiger Betriebsstrom eingeprägt, so besitzen am Ende eines jeden Abgleichszyklusses alle MOS-Transistoren unabhängig von der Betriebstemperatur in guter Näherung immer die jeweils vorgesehene effektive Gatespannung Vgeff und damit, wie später näher erläutert, auch die jeweils vorgesehene Kleinsignalsteilheit gm sowie die vorgesehene Transitfrequenz fT, die damit ebenfalls temperaturunabhängig sind.

Figur 2 zeigt eine Weiterbildung des Ausführungsbeispiels von Figur 1, welches diesem in wesentlichen Schaltungsteilen, den verwendeten Bauteilen, deren Zusammenschaltung sowie vorteilhafter Funktionsweise entspricht. Insoweit wird die Beschreibung an dieser Stelle nicht wiederholt.

Die Spannungsquelle 8 ist bei Figur 2 als Transistordiode ausgeführt. Hierfür ist ein MOS-Transistor vorgesehen, dessen Gateanschluß mit seinem Drainanschluß und damit auch mit dem Widerstand 7 verbunden ist. Der Verstärker 3 ist nach dem sogenannten Square-Law-Prinzip ausgebildet. Hierfür ist zusätzlich zu dem zumindest einen Transistor 1 ein weiterer Transistor 11 vorgesehen. Zwischen den Gateanschlüssen der Transistoren 1, 11 kann ein Eingangsspannungssignal Uin zugeführt werden, welches vorliegend durch die Spannungsquelle 14 repräsentiert ist. Weiterhin sind die Gateanschlüsse der Transistoren 1, 11 über je einen Vorwiderstand 12 mit dem zweiten Schaltungsknoten K2 verbunden. Die Sourceanschlüsse der Transistoren 1, 11 sind mit Bezugspotentialanschluß 9 verbunden. Die Drainanschlüsse der Transistoren 1, 11 bilden den Ausgang des Verstärkers und sind zudem über je einen Lastwiderstand 13 gegen Versorgungspotentialanschluß VDD geschaltet. Sowohl die Kanalweite des Transistors 1, als auch die Kanalweite des Transistors 11, wird durch das Steuerwort der Wortbreite i Bit der Steuereinheit 2 verändert. Die MOS-Einsatzspannung VTH0 wird mit Hilfe des Transistors 8 gewonnen, indem dieser für den Strom IREF1 so dimensioniert ist, daß der Spannungsabfall von Drain nach Source möglichst exakt gerade der MOS-Einsatzspannung VTH0 entspricht. Dann arbeitet der Transistor 8 in moderater Kanalinversion beziehungsweise an der Grenze zum Unterschwellenspannungsbereich. Am Ende eines Temperatur-Abgleichzyklusses ist die effektive Gatespannung Vgeff des Transistors 10 gleich oder ungefähr gleich dem Produkt aus Wert des Widerstands R1 und Referenzstrom IREF1. Die Spannung UK2 am zweiten Schaltungsknoten K2 wird mit Hilfe der Widerstände 12 auf die Gateanschlüsse der Transistoren 1, 11 übertragen. Die effektive Gleichtakt-Gatespannung der Transistoren 1, 11 hat daher denselben Wert wie die effektive Gatespannung des Transistors 10. Das digitale Steuerwort liegt gleichzeitig an den Transistoren 1, 11, 10 an. Das Stromverhältnis zwischen dem zweiten Referenzstrom IREF2 und dem dritten Referenzstrom IREF3 in den beiden Zweigen 1, 11 des Verstärkers 3 bleibt unabhängig vom Digitalwort immer gleich. Für den Fall, daß der zweite Referenzstrom IREF2 über der Temperatur konstant bleibt, ist in allen geometriegesteuerten MOS-Transistoren 1, 10, 11 ein temperaturunabhängiger Gleichtakt-Betriebsstrom eingeprägt. Sie besitzen daher am Ende eines Abgleichszyklusses unabhängig von der Betriebstemperatur in guter Näherung immer die jeweils vorgesehene effektive Gatespannung Vgeff und damit, wie nachfolgend näher erläutert, die jeweils vorgesehene Kleinsignalsteilheit und Transitfrequenz. Demnach wird gemäß den Gesetzen der Square-Law-Verstärker die differentielle Eingangsspannung Uin linear mit der Steilheit gm3 des Verstärkers 3 in einen differentiellen Ausgangsstrom am Ausgang des Verstärkers 3 umgesetzt, der sich wiederum an den Lastwiderständen 13 in eine Ausgangsspannung Uout umsetzt. Für die Spannungsverstärkung des Verstärkers 3, die sich aus den Quotienten der differentiellen Ausgangsspannung Uout zur differentiellen Eingangsspannung Uin berechnet, gilt damit, daß diese gleich dem Produkt aus Kleinsignalsteilheit gm des Verstärkers 3 und dem doppelten Wert RL des Lastwiderstands 13 ist. Auch die effektive Gleichtakt-Gate-Spannung und damit die verarbeitbare Spannungsdynamik bleibt konstant.

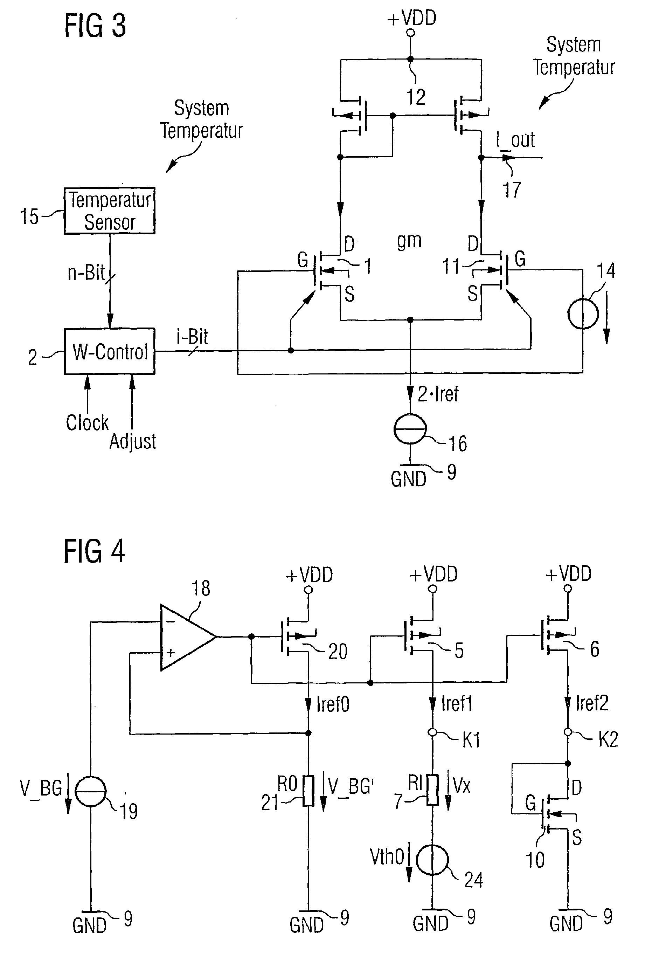

Figur 3 zeigt ein weiteres Ausführungsbeispiel einer Transistoranordnung mit Temperaturkompensation. Es ist ein Temperatursensor 15 vorgesehen, der über eine digitale Schnittstelle der Wortbreite n Bit mit der Steuereinheit 2 verbunden ist. Ausgangsseitig ist die Steuereinheit 2, deren Aufbau bereits in Figuren 1 und 2 beschrieben wurde, mit Transistoren 1, 11 einer Verstärkeranordnung zur Steuerung der Kanalweite der Transistoren 1, 11 in Abhängigkeit von der gemessenen Temperatur gekoppelt. Zwischen den Gateanschlüssen der Transistoren 1, 11 ist ein differentieller Eingang 14 gebildet. Die Sourceanschlüsse der Transistoren 1, 11 sind über eine gemeinsame Stromquelle 16 gegen den Bezugspotentialanschluß 9 geschaltet. Die Drainanschlüsse der Transistoren 1, 11 sind über einen Stromspiegel 12 miteinander verbunden. Die Stromspiegeltransistoren des Stromspiegels 12 sind mit dem Versorgungspotentialanschluß VDD verbunden. Am Verbindungsknoten des Stromspiegels 12 mit dem Transistor 11 ist ein Single-Ended- Ausgang 17 des Verstärkers gebildet, an dem ein Eintakt-Ausgangssignal bereitgestellt wird.

Der Verstärker von Figur 3 ist ein Differenzverstärker 1, 11, 12. In der Steuereinheit 2 ist eine Tabelle abgelegt, die der jeweils gemessenen Temperatur die geeignete Kanalweite zuordnet. Mit Vorteil können damit auch die Merkmale des Differenzverstärkers 1, 11, 12 wie Kleinsignalsteilheit und/oder statisches Übertragungsverhalten der Differenzstufe konstant gehalten werden. Man erkennt, daß die Erfindung nicht auf Anwendung des Square-Law-Prinzips beschränkt ist.

Die Transistoren 1, 11 der Eingangsdifferenzstufe des Differenzverstärkers 1, 11, 12 sind bezüglich ihrer Kanalweite W digital programmierbar. Im Ruhelagepunkt, das heißt bei einer Eingangsspannung Uin von 0 am Eingang 14, fließt durch die Transistoren 1, 11 jeweils der temperaturunabhängige Referenzstrom Iref, der von der Stromquelle 16 bereitgestellt wird. Die Transistoren 1, 11 arbeiten dann in starker Kanalinversion. Da die effektive Gatespannung Vgeff der Transistoren 1, 11 der Eingangsdifferenzstufe bei konstantem Referenzstrom Iref keine Funktion von der Gleichtaktlage der Spannung am Eingang 14 ist, läßt sich durch geeignete Veränderung des digitalen Abgleichwortes der Steuereinheit I erreichen, daß die Steilheit gm des Differenzverstärkers 1, 11, 12 im Rahmen, der digitalen Einstellgenauigkeit über der Betriebstemperatur näherungsweise konstant bleibt. Entsprechendes gilt für das statische Übertragungsverhalten zwischen Eingangsspannung Uin am Eingang 14 und Ausgangsstrom Iout am Eintaktausgang 17.

Figur 4 zeigt ein Ausführungsbeispiel einer Schaltungsanordnung zur Gewinnung eines temperaturunabhängigen Referenzstroms Iref1, wie er in den Schaltungen von Figur 1 und Figur 2 angewendet werden kann. Außerdem dient die Schaltung auch zur Erzeugung eines weiteren Referenzstroms Iref2 für den Transistor 10 mit einstellbarer Kanalweite im Regelkreis von Figur 1. Der temperaturunabhängige Referenzstrom Iref wird dabei in der Art aus der Bandgap-Schaltung gewonnen, daß der Spannungsabfall über einem Widerstand der Bandgapspannung VBG entspricht und wie diese temperaturstabil ist. Es ist bei der Schaltung von Figur 4 ein Differenzverstärker 18 vorgesehen mit einem invertierenden Eingang, der über eine Bandgap-Spannungsquelle 19 gegen Bezugspotential 9 geschaltet ist. Der Ausgang des Operationsverstärkers 18 ist über einen gesteuerten MOS-Transistor 20 auf den nicht-invertierenden Eingang des Operationsverstärkers 18 rückgeführt. Letzterer ist zudem über einen Widerstand 21 gegen Bezugspotential geschaltet. Der Ausgang des Operationsverstärkers 18 steuert einen weiteren Transistor 5 an, dessen gesteuerte Strecke einerseits mit einem Versorgungspotentialanschluß VDD verbunden und andererseits über einen Widerstand 7 und eine Spannungsquelle 24 gegen Bezugspotentialanschluß 9 geschaltet ist. Der weitere Transistor 5 arbeitet als Stromquelle. Die Stromquelle 24 stellt die Schwellspannung VTH0 eines MOS-Transistors bereit. Der Ausgang des Operationsverstärkers 18 ist weiterhin mit dem Steuereingang eines als Stromquelle arbeitenden Transistors 6 verbunden. Die gesteuerte Strecke des Transistors 6 ist zwischen dem Versorgungspotentialanschluß VDD und dem Bezugspotentialanschluß 9 in Serie mit dem Transistor 10 angeordnet.

Die Spannungsquelle 19 liefert eine temperaturstabile Bandgap-Spannung VBG mit typischem Spannungswert von 1,2 V. Die Regelschleife 18, 20, 21 sorgt dafür, daß über dem Widerstand 21 die Spannung VBG' ansteht, die ungefähr gleich der Bandgap-Spannung VBG ist. Es gilt:

$$Iref0 = \frac{V\_BG'}{R0} \approx \frac{V\_BG}{R0},$$

wobei R0 der Widerstandswert des Widerstands 21 ist. Für den Fall, daß die PMOS-Stromquellen-Transistoren 20, 5 identisch sind, fließt in beiden Transistoren näherungsweise der gleiche Strom, soweit die Spannungsabfälle von Drain nach Source jeweils hinreichend groß sind. Für den Fall, daß der Widerstand 21 ebenso wie der Widerstand 7 einen vernachlässigbaren Temperaturgang besitzt, ist der Referenzstrom IREF, der den Widerstand 7 durchfließt, praktisch temperaturunabhängig. Sind die Transistoren 20, 5 baugleich und der Spannungsabfall von Drain nach Source hinreichend groß, so berechnet sich der Spannungsabfall Vx über dem Widerstand 7. berechnet sich zu

$$Vx \approx V\_BG \cdot \frac{R1}{R0},$$

wobei R0 den Widerstandswert des Widerstands 21 und R1 den Widerstandswert des Widerstands 7 bezeichnet. Die Widerstände 21, 7 sind dabei mit Vorteil typidentisch ausgeführt.

Vorliegend ist der Widerstand R1 nicht unmittelbar an Masse geschaltet, sondern über die Spannung VTH0, welche sich auf die Spannung Vx addiert, falls der Referenzstrom keine Spannungsabhängigkeit zeigt, auf Masse bezogen.

Mit Vorteil entspricht der Widerstand 7 von Figur 4, an dem der Referenzstrom Irefl eingeprägt wird, dem Widerstand 7 von Figuren 1 und 2. Ebenso entspricht die Stromquelle 24 von Figur 4 analog der Spannungsquelle 8 von Figuren 1 und 2.

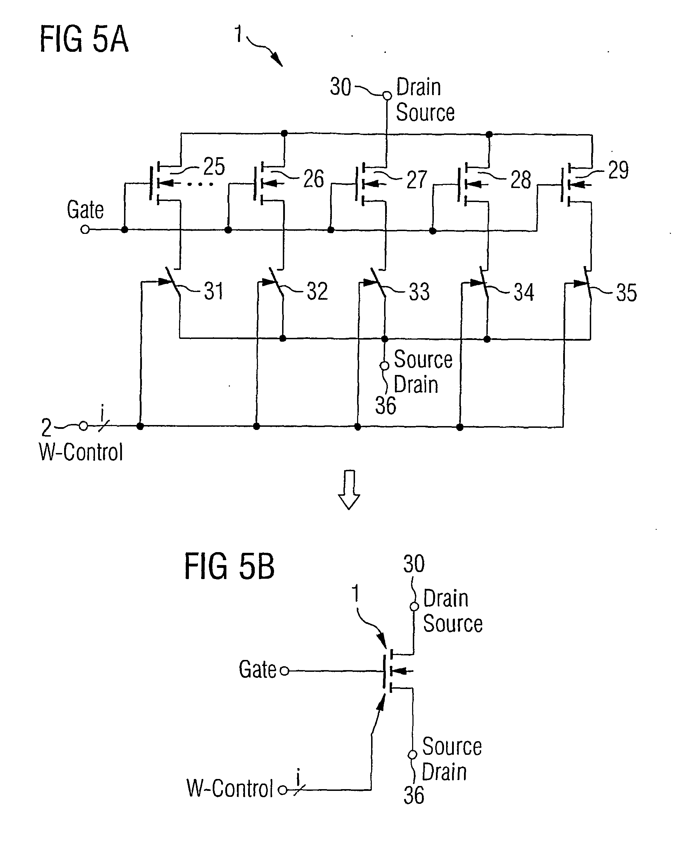

Figur 5a zeigt ein Ausführungsbeispiel des zumindest einen Transistors 1 mit einstellbarer Kanalweite W. Der Transistor umfaßt dabei 5 Teiltransistoren 25, 26, 27, 28, 29, deren Gateanschlüsse unmittelbar miteinander verbunden sind und den Gateanschluß des Transistors 1 bilden und deren erste Drain-Source-Anschlüsse ebenfalls in einem gemeinsamen Knoten 30 miteinander verbunden sind. Die zweiten Drain-Source-Anschlüsse der Teiltransistoren 25 bis 29 sind über je einen Schalter 31, 32, 33, 34, 35 mit einem zweiten, gemeinsamen Drain-Source-Knoten 36 verbunden. Die Steuereingänge der Schalter 31 bis 35 sind mit dem Ausgang der Steuereinheit 2 verbunden. Somit können die Schalter 31 bis 35 in Abhängigkeit von der gewünschten Gesamt-Kanalweite unabhängig voneinander zu- und abgeschaltet werden.

Figur 5b zeigt ein Ersatzschaltbild des Transistors 1 von Figur 5a mit einstellbarer Kanalweite W.

Der Transistor 1 gemäß Figuren 5a, 5b eignet sich zur Anwendung als Transistor mit einstellbarem Geometrieparameter in den Transistoranordnungen mit Temperaturkompensation gemäß Figuren 1, 2 und 3.

Da bei festen Potentialen am MOS-Transistor 1 der Drainstrom linear proportional mit der Weite skaliert, kann man einen bezüglich der Weite digital programmierbaren Transistor aus i bezüglich Drain, Gate, Source und Bulk parallel geschalteten Teiltransistoren mit jeweils einem Serienschalter im Strompfad des Teiltransistors bilden. Der Serienschalter kann sich im Drain-Pfad, im Source-Pfad oder gleichzeitig in beiden befinden. Die Staffelung der Kanalweiten der Teiltransistoren 25 bis 29 kann mit Vorteil binär gewichtet sein gemäß der Vorschrift $2^n$. Denkbar sind jedoch auch beliebige andere Unterteilungen, je nach geforderter Anwendung.

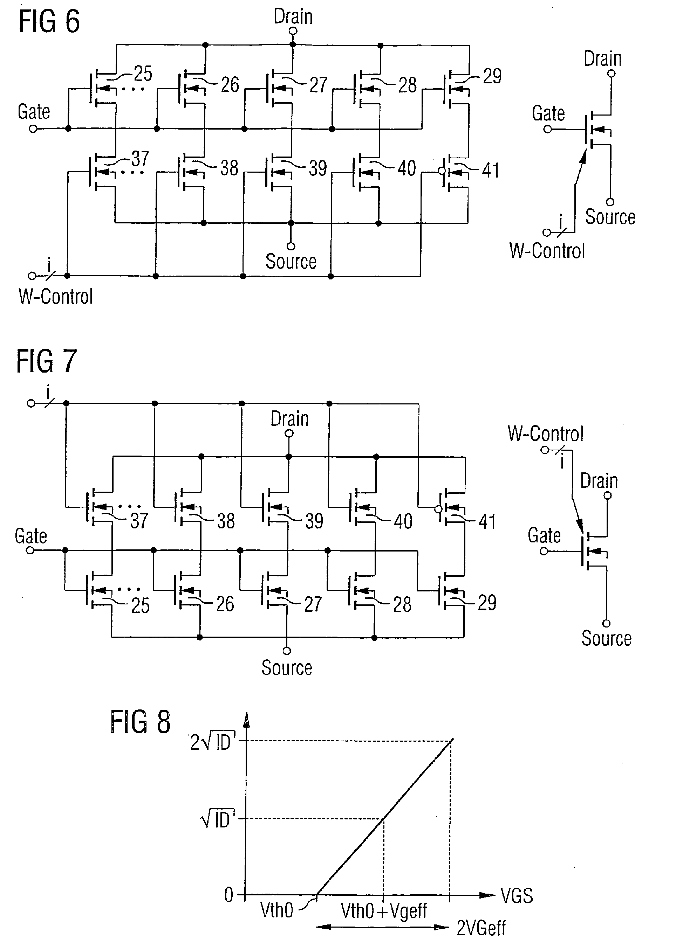

Figur 6 zeigt eine Weiterbildung der Schaltung von Figur 5a, die dieser in Aufbau und Funktionsweise weitgehend entspricht. Die Schalter 31 bis 35, die den Teiltransistoren 25 bis 29 zugeordnet sind, sind vorliegend als schaltend betriebene MOS-Transistoren 37 bis 41 realisiert. Die Steuereingänge der Schalter 37 bis 41 bilden ihre Gateanschlüsse. Die gesteuerte Strecke ist die Source-Drain-Strecke.

Um einen Transistor bezüglich seiner elektrisch wirksamen Kanalweite elektronisch einstellbar zu machen, können die Schalter in Reihe zum Drainanschluß oder in Reihe zum Sourceanschluß der Teiltransistoren 25 bis 29 angeordnet sein. Aus Gründen der Paarigkeit aller Schalter sind diese entweder alle im Source-Pfad oder bevorzugt alle im Drain-Pfad angeordnet.

Figur 7 zeigt die Schaltung von Figur 6, bei der jedoch die Schalter 37 bis 41 im Drain-Pfad der Teiltransistoren 25 bis 29 angeordnet sind. Die Anordnung der Schalter 37 bis 41 im Drain-Pfad der Teiltransistoren 25 bis 29 hat den Vorteil, daß aufgrund der Verschaltung Spannungsabfälle über den Schaltern praktisch ohne Auswirkungen auf die Verstärkungseigenschaften der Stufe sind.

Figur 8 zeigt anhand eines Schaubildes den sogenannten Square-Law-Dynamikbereich, der ein Auslenkungsbereich um den Arbeitspunkt ist. Der Arbeitspunkt berechnet sich aus der Summe der Schwellspannung VTH0 und der effektiven Gatespannung Vgeff. Der Auslenkungsbereich entspricht damit der doppelten effektiven Gatespannung 2. Vgeff, da der nach unten durch die Schwellspannung VTH0 begrenzt ist. In Figur 8 ist die Wurzel aus dem Drainstrom ID über der Gate-Source-Spannung VGS aufgetragen, so daß sich ein linearer Zusammenhang ergibt. Im Auslenkungsbereich, dem sogenannten Square-Law-Bereich, welcher der doppelten, effektiven Gatespannung entspricht, ergibt sich ein lineares Verhalten für Schaltungen, die auf der Basis des Square-Law Prinzips lineare Operationen erlauben. Demnach ist es wünschenswert, daß wie mit dem vorgeschlagenen Prinzip gerade erzielt, die effektive Gatespannung unabhängig von der Temperatur ist. Somit folgt für den Square-Law-Bereich, daß die verarbeitbare Dynamik eines Square-Law-Verstärkers temperaturunabhängig ist.

Nachfolgend soll die Bedeutung der Konstanz der Steilheit gm über der Temperatur erläutert werden.

Es gilt in erster Ordnung für den MOS-Drainstrom ID bei starker Kanalinversion:

$$ID = B \cdot Vgeff^2, \quad Vgeff = Ugs - Vt,$$

dabei repräsentiert ID den Drainstrom, B eine Konstante, Vgeff die effektive Gate-Spannung, Ugs die Gate-Source-Spannung und Vt die Temperaturspannung.

Die MOS-Kleinsignal-Steilheit gm ist definiert als:

$$gm = \frac{\partial ID}{\partial Ugs} = \frac{\partial ID}{\partial Vgeff}$$

Aus den den genannten Formeln folgt für die MOS-Kleinsignal-Steilheit gm:

$$\Rightarrow gm = 2 \cdot B \cdot Vgeff$$

und

$$\Rightarrow gm = \frac{2 \cdot ID}{Vgeff}.$$

Aus der letzten Formel folgt, daß bei konstanter effektiver Gatespannung und konstantem Drainstrom die Steilheit gm konstant ist.

Dadurch ist aber auch die Transitfrequenz fT konstant, da die Transitfrequenz definiert ist als Quotient der Steilheit gm geteilt durch den MOS-Gate-Source-Kapazitätsbelag Cgs

$$fT = \frac{gm}{2\pi \cdot Cgs}.$$

der Kapazitätsbelag Cgs hat praktisch keine Temperaturabhängigkeit, so daß bei den Voraussetzungen ID gleich konstant und Vgeff gleich konstant auch folgt, daß die Transitfrequenz fT konstant ist.

Wird ein einfacher MOS-Verstärker mit einem Lastwiderstand und einem MOS-Transistor aufgebaut, so gilt in erster Näherung für die Kleinsignalspannungsverstärkung Vu mit einer Widerstandslast RL:

$$Vu = \frac{u\_out}{u\_in} = \frac{gm}{\dfrac{1}{RL}} = gm \cdot RL$$

Wird für die wirksame Last RL eine Temperatur-Unabhängigkeit vorausgesetzt, so folgt mit den obigen Voraussetzungen dafür, daß die Steilheit konstant ist, auch, daß die Spannungsverstärkung Vu konstant ist.

Demnach bleibt festzuhalten, daß bei konstantem Drainstrom ID und konstanter effektiver Gatespannung Vgeff' auch die Spannungsverstärkung Vu und die Transitfrequenz fT sowie die Kleinsignalsteilheit gm konstant bleiben.

Nachfolgend wird der Zusammenhang zwischen effektiver Gate-Spannung und der Transistorgeometrie eines MOS-Transistors erläutert:

Für den MOS-Drainstrom ID gilt in erster Ordnung bei starker Kanalinversion:

$$ID = B \cdot Vgeff^2 \, ,$$

wobei

$$B = KP \cdot \left(\frac{T}{Tnom}\right)^{-\frac{3}{2}} \cdot \frac{W}{2 \cdot L}$$

$$Vgeff = Ugs - Vt.$$

Dabei repräsentiert T die Temperatur in Kelvin, $T_{nom}$ die Bezugstemperatur in Kelvin, für die KP angegeben ist und KP eine Technologiekonstante, die die Beweglichkeit und die Oxid-Dicke berücksichtigt. Für konstanten Drainstrom ID folgt für den notwendigen Temperaturgang der effektiven Gatespannung:

$$\Rightarrow Vgeff \propto \left(\frac{T}{Tnom}\right)^{\frac{3}{4}}$$

Die effektive Gatespannung Vgeff nimmt mit der Temperatur zu. Um Vgeff bei konstantem Strom ID ebenfalls konstant zu halten, müssen die Transistorgeometrien Weite W und/oder Länge L des Kanals geeignet verändert werden. Unter Voraussetzung der Gültigkeit des Temperaturgangs muß dann gelten:

$$\frac{W_T}{L_T} = \frac{W_{Tnom}}{L_{Tnom}} \cdot \left(\frac{T}{Tnom}\right)^{\frac{3}{2}}$$

Der Quotient $W_T / L_T$ ist das erforderliche Geometrieverhältnis bei der aktuellen Temperatur in Kelvin, welches notwendig ist, damit die effektive Gatespannung bei festem Drainstrom konstant bleibt. Der Quotient $W_{Tnom} / L_{Tnom}$ ist das erforderliche Geometrieverhältnis bei der nominalen Bezugstemperatur in Kelvin, das notwendig ist, damit die effektive Gatespannung bei der nominalen Bezugstemperatur den gewünschten Nennwert hat.

Um die effektive Gatespannung konstant über der Temperatur zu halten, genügt es beispielsweise, nur eine Transistorgeometrie, nämlich Weite oder Länge, geeignet zu verändern. Aus obiger Formel folgt dann für die Transistorweite:

$$W_T = W_{Tnom} \cdot \left(\frac{T}{Tnom}\right)^{\frac{3}{2}} \quad \text{mit} \quad L_T = L_{Tnom} = L$$

$W_T$ ist bei fester Kanallänge L die erforderliche Transistorweite bei der aktuellen Temperatur in Kelvin, die notwendig ist, damit die effektive Gatespannung konstant bleibt. Für die Transistorlänge $L_T$ gilt entsprechend:

$$L_T = L_{Tnom} \cdot \left(\frac{T}{Tnom}\right)^{\frac{3}{2}} \quad \text{mit} \quad W_T = W_{Tnom} = W$$

$L_T$ ist bei fester Kanalweite W die erforderliche Transistorlänge bei der aktuellen Temperatur in Kelvin, die notwendig ist, damit die effektive Gatespannung Vgeff konstant bleibt.

Selbstverständlich ist eine Transistorgeometrie im Layout eine feststehende, unveränderliche Größe. Vorliegend wird der Transistor jedoch bevorzugt aus einer Vielzahl einzelner MOS-Transistoren zusammengesetzt, wobei durch Schalten mittels Schaltern eine Teilmenge der Transistoren dem wirksamen MOS-Transistor hinzugefügt oder weggenommen wird. Die wirksame MOS-Transistorgeometrie ist dann also in diskreten Schritten digital einstellbar gemacht.

Die nachstehende Tabelle beschreibt den Temperaturgang für die erforderliche Veränderung der Transistorweite bei fester Kanallänge und bei festem Drainstrom, die nach obigen mathematischen Zusammenhängen notwendig ist, um die effektive Gate-Spannung konstant zu halten. Tnom beträgt dabei -40 Grad Celsius, also ca. 233 Grad Kelvin.

| | X = -40˚C | X = +27˚C | X = +100˚C | X = +140˚C |
|---|---|---|---|---|
| $\left(\dfrac{273 + X}{273 - 40}\right)^{\frac{3}{2}}$ | 1.00 | 1.46 | 2.03 | 2.36 |

In den nachstehenden Tabellen ist für unterschiedliche Werte der effektiven Gate-Spannung gezeigt, wie sich bei fester Kanallänge und bei festem Drainstrom die Kanalweite W ändern muß, damit die effektive Gate-Spannung jeweils über der Temperatur konstant bleibt.

| | -40˚C | +27˚C | +100˚C | +140˚C |
|---|---|---|---|---|
| Vgeff | 300mV | 300mV | 300mV | 300mV |
| $\Rightarrow W$ | 3.3um (*1.00) | 4.73um (*1.43) | 6.8um (*2.06) | 8.29um (*2.51 ) |
| $\Rightarrow gm$ | 544.60uS (*1.00) | 574.68uS (*1.06) | 626.32uS (*1.15) | 660.71 uS (*1.21) |

| | -40˚C | +27˚C | +100˚C | +140˚C |
|---|---|---|---|---|
| Vgeff | 200mV | 200mV | 200mV | 200mV |
| $\Rightarrow W$ | 6.53um (*1.00) | 9.77um (*1.5) | 15.08um (*2.31) | 19.11 um (*2.93) |
| $\Rightarrow gm$ | 0.833mS (*1.00) | 0.893mS (*1.07) | 0.974mS (*1.17) | 1.007mS (*1.21) |

| | -40˚C | +27˚C | +100˚C | +140˚C |
|---|---|---|---|---|
| Vgeff | 100mV | 100mV | 100mV | 100mV |
| $\Rightarrow W$ | 20.14um (*1.00) | 32.1um (*1.59) | 52.19um (*2.59) | 66.45um (*3.3) |

(fortgesetzt)

| | -40˚C | +27˚C | +100˚C | +140˚C |
|---|---|---|---|---|
| ⇒ gm | 1.48mS (*1.00) | 1.52mS (*1.02) | 1.5mS (*1.01) | 1.45mS (*0.98) |

Dabei wurden folgende Parameter angenommen: Kanalweite 0,5um, der Drainstrom 100uA, die Schwellspannung 0,4V, TOX 6nm und n-Kanal-Typ. Vgeff bezeichnet die effektive Gate-Spannung, W die Kanalweite und gm die Steilheit.

Der Vergleich der theoretischen Veränderung 1. Ordnung der Transistorweite nach obiger Formel mit den simulierten Veränderungen gemäß der Tabelle zeigt recht gute Übereinstimmung. Gleichzeitig zeigen die Tabellen, daß bei dem gewählten MOS-Simulationsmodell bei konstantem Drainstrom und konstanter effektiver Gate-Spannung auch die Steilheit gm praktisch Konstant ist.

Nachfolgend wird im Gegensatz zu obiger Untersuchung nicht dem vorgeschlagenen Prinzip entsprechend die Transistorgeometrie, sondern der Drainstrom verändert, um die effektive Gate-Spannung konstant zu halten. Dabei wurde das gleiche Simulationsmodell mit identischen Randbedingungen verwendet.

| | -40˚C | +27˚C | +100˚C | +140˚C |
|---|---|---|---|---|
| Vgeff | 300mV | 300mV | 300mV | 300mV |
| ⇒ ID | 151uA (*1.00) | 106uA (*0.70) | 74uA (*0.49) | 60uA (*0.4) |
| ⇒ gm | 823uS (*1.00) | 607uS (*0.74) | 461 uS (*0.56) | 399uS (*0.48) |

| | -40˚C | +27˚C | +100˚C | +140˚C |
|---|---|---|---|---|
| Vgeff | 200mV | 200mV | 200mV | 200mV |
| ⇒ ID | 76.6uA (*1.00) | 51.3uA (*0.67) | 33.3uA (*0.43) | 26.2uA (*0.34) |
| ⇒ gm | 638uS (*1.00) | 458uS (*0.72) | 323uS (*0.51) | 264uS (*0.41) |

| | -40˚C | +27˚C | +100˚C | +140˚C |
|---|---|---|---|---|
| Vgeff | 100mV | 100mV | 100mV | 100mV |
| ⇒ ID | 24.9uA (*1.00) | 15.6uA (*0.63) | 9.6uA (*0.39) | 7.6uA (*0.30) |
| ⇒ gm | 369uS (*1.00) | 237uS (*0.64) | 144uS (*0.39) | 109uS (*0.3) |

Man erkennt, daß bei Kompensation mittels Drainstrom anstelle Transistorgeometrie die erforderliche Stromänderung sehr groß ist und zudem die Steilheit nicht konstant bleibt, sondern sich ebenfalls stark ändert.

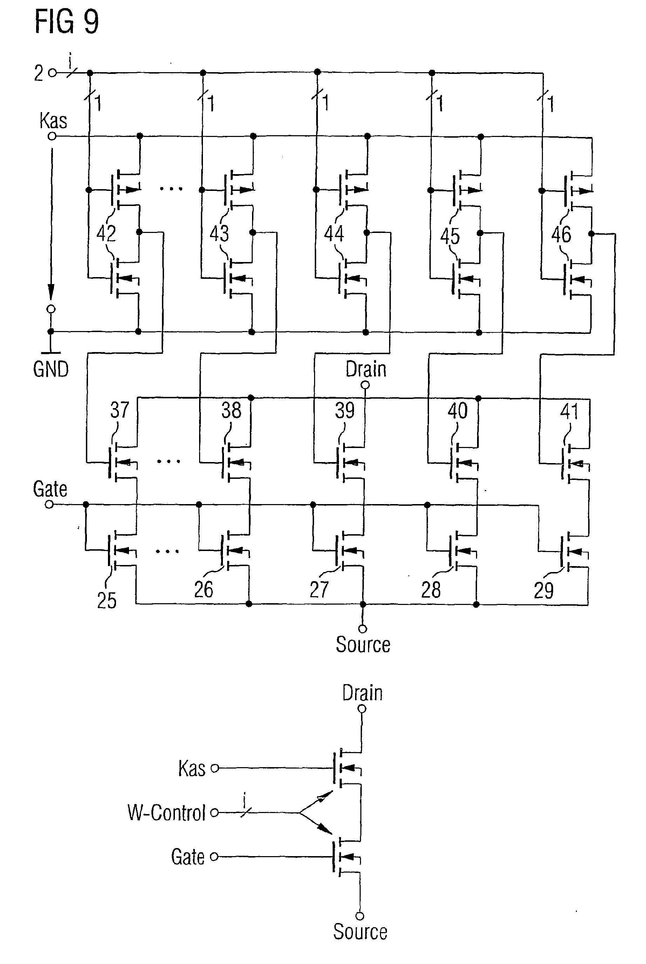

Figur 9 zeigt anhand eines Ausführungsbeispiels einen MOS-Transistor mit einstellbarer Kanalweite, bei dem eine Kaskode-Stufe vorgesehen ist, welche zugleich als Schalter dient.

Die Teiltransistoren sind wie bei Figuren 5a, 6 und 7 verschaltet und mit Bezugszeichen 25, 26, 27, 28, 29 bezeichnet. In die Drainzweige der Teiltransistoren 25 bis 29 ist, wie bereits in Figur 7 gezeigt, je ein Schalttransistor 37, 38, 39, 40, 41 geschaltet, der zugleich eine Kaskode-Stufe für den Teiltransistor 25, 26, 27, 28, 29, der ihm zugeordnet ist, bildet. Die Ansteuerung der als Schalter arbeitenden Kaskode-Transistoren 37, 38, 39, 40, 41 erfolgt jedoch nicht unmittelbar mit der Steuereinheit 2, sondern es ist jeweils eine Inverterstufe 42, 43, 44, 45, 46 zwischengeschaltet, deren Ausgang mit dem zugeordneten Steuereingang der Schalter 37 bis 41 verbunden ist. Die Eingänge der Inverter 42, 43, 44, 45, 46 sind mit dem Ausgang der Steuereinheit 2 verbunden. Die Versorgungsspannung VKAS der Inverter ist so gewählt, daß bei Aktivieren des jeweiligen Inverters die gewünschte Kaskodespannung als analoge Referenzspannung am jeweiligen Kaskode-Transistor 37, 38, 39, 40, 41 ansteht und dadurch zugleich der jeweilige zugeordnete Teiltransistor 25, 26, 27, 28, 29 aktiv geschaltet ist. Bei einer logischen Null am Inverterausgang hingegen wird der Kaskode-Transistor stromlos geschaltet, das heißt der zugeordnete Teiltransistor ist inaktiv. Somit können problemlos und platzsparend die Funktionen einer Kaskodeschaltung mit der der Schalttransistoren kombiniert werden.

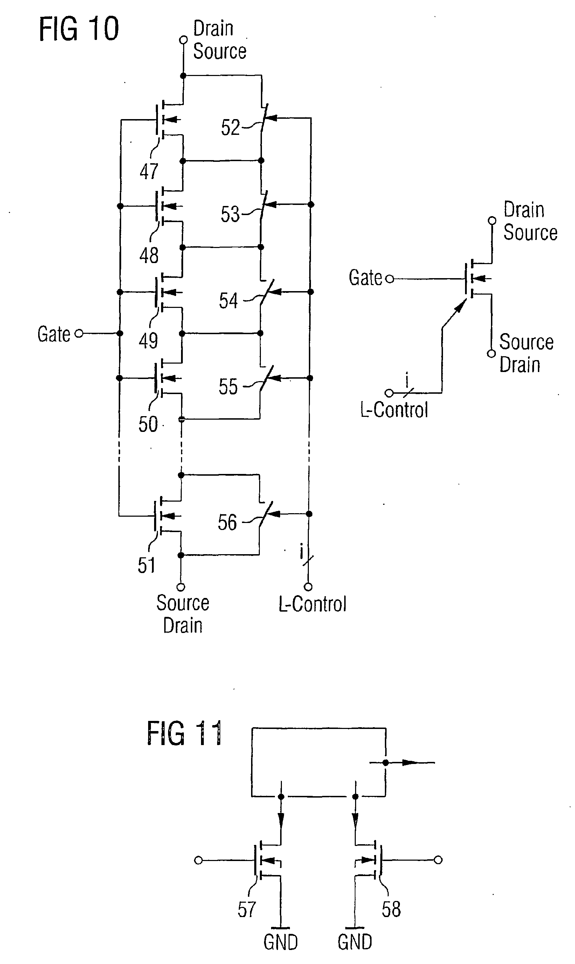

Figur 10 zeigt ein Ausführungsbeispiel eines Transistors mit einstellbarer Kanallänge. Es ist eine Vielzahl von Teiltransistoren 47, 48, 49, 50, 51 vorgesehen, welche bezüglich ihrer gesteuerten Strecken eine Serienschaltung bilden. Parallel zu jeder gesteuerten Strecke der Teiltransistoren 47 bis 51 ist ein Schalter 52, 53, 54, 55, 56 vorgesehen, wobei die Schalter durch die Steuereinheit 2 angesteuert werden. Da bei festen Potentialen am MOS-Transistor der Drainstrom umgekehrt proportional linear mit der Länge skaliert, repräsentiert die Schaltung von Figur 10 einen bezüglich der Kanallänge digital programmierbaren Transistor. Die Staffelung der Längen der Teiltransistoren 47, 48, 49, 50, 51 kann beispielsweise binär gewichtet sein, wobei auch andere Unterteilungen vorteilhaft sein können.

Selbstverständlich können die Einstellungen der Kanalweite und Kanallänge wie beispielsweise in Figur 5a und Figur 10 gezeigt auch miteinander kombiniert werden.

Figur 11 zeigt das Grundprinzip eines Square-Law-Verstärkers, mit dessen Beispiel weitere vorteilhafte Eigenschaften des vorgeschlagenen Prinzips erklärt werden sollen.

Die Gate-Potentiale der MOS-Transistoren 57, 58 des Verstärkers von Figur 11 werden exakt gegensinnig um die Gleichtaktlage ausgelenkt, die sich aus der Summe der Schwellspannung Vth0 und der effektiven Gatespannung Vgeff, wie in Figur 8 gezeigt, berechnet. Um diese Gleichtaktlage werden die Transistoren um den Betrag der Eingangsspannung Uin gegensinnig ausgelenkt. In erster Näherung gilt für den Drainstrom bei starker Kanalinversion:

$$ID = B \cdot Vgeff^2, \quad Vgeff = Ugs - Vt$$

$$\left(Vsb = 0 \Rightarrow Vt = Vth0\right)$$

Der interessante Signalausgangsstrom ΔIOUT aus dem Verstärker ergibt sich aus den beiden Stromzweigen des Verstärkers zu:

$$\Delta Iout = IDr - IDl$$

Somit gilt für die Teilströme ID1 und IDr:

$$IDr = B \cdot \left(Vgeff - Uin/2\right)^2$$

$$IDl = B \cdot \left(Vgeff + Uin/2\right)^2$$

Dadurch folgt für den Signalausgangsstrom ΔIOUT:

$$\Rightarrow \Delta Iout = B \cdot 2 \cdot Vgeff \cdot Uin$$

Es soll bemerkt werden, daß der Ausgangsstrom linear proportional ist zur Eingangsspannung.

Die Kleinsignalsteilheit gm ist definiert zu

$$gm = \frac{\partial(\Delta Iout)}{\partial Uin}$$

Es ergibt sich für die Kleinsignalsteilheit:

$$\Rightarrow gm = B \cdot 2 \cdot Vgeff$$

Man erkennt, daß die Kleinsignalsteilheit keine Funktion der Eingangsspannung ist. Dadurch ist die Kleinsignalsteilheit gleich der Großsignalsteilheit

$$\Rightarrow gm = Gm \ ,$$

so daß eine gute Großsignallinearität gegeben ist.

Dadurch gilt für den Ausgangsstrom und die Großsignalsteilheit

$$\Rightarrow \Delta Iout = Gm \cdot Uin$$

$$Gm = gm = B \cdot 2 \cdot Vgeff$$

Letzte Gleichung ist solange erfüllt, wie die sich zu dem Ausgangsstrom zusammensetzenden Teil-Drainströme lDr, ID1 größer Null sind.

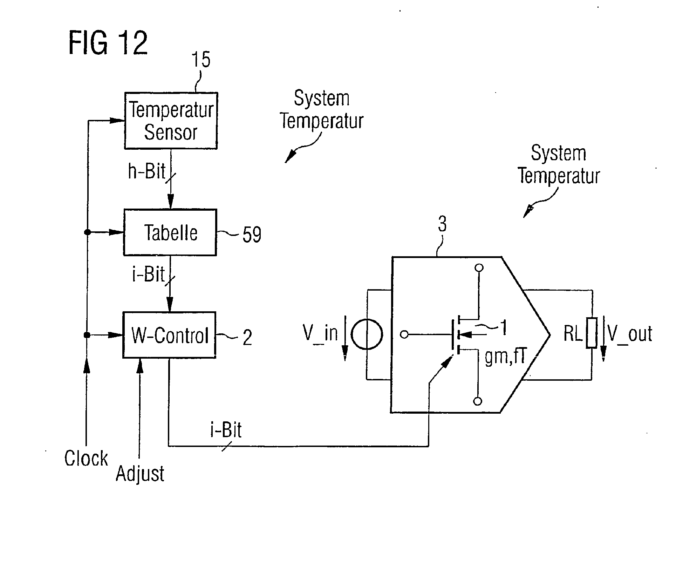

Figur 12 zeigt ein Beispiel einer Transistoranordnung mit Temperaturkompensation. Es ist ein Verstärker 3 vorgesehen, der zumindest einen Transistor 1 mit zumindest einem einstellbaren Geometrieparameter umfaßt. Vorliegend ist die Kanalweite des Transistors 1 in diskreten Schritten einstellbar. Hierfür ist eine Steuereinheit 2 vorgesehen, deren Ausgang über eine Leitung der Wortbreite i Bit mit dem Verstärker 3 gekoppelt ist. Ein Temperatursensor 15 ist über eine Zuordnungstabelle, englisch: Look-Up-Table 59, mit der Steuereinheit 2 gekoppelt.

Die Zuordnungstabelle 59 ordnet jedem Temperaturwert ein digitales Steuersignal zu, in dessen Abhängigkeit die Steuereinheit den Transistor 1 im Verstärker 3 gerade so bezüglich seiner Kanalweite einstellt, daß die Transistorkenngrößen wie Steilheit, Transitfrequenz und Stromverbrauch über dem Temperaturbereich konstant oder weitgehend konstant bleiben. Die Zuordnungstabelle 59 kann in digitaler Schaltungstechnik besonders einfach implementiert werden.

Alle gezeigten Ausführungsbeispiele können im Rahmen der Erfindung selbstverständlich auch in komplementärer Schaltungstechnik ausgeführt werden. So sind beispielsweise MOS-Stromquellen sowohl mit n-Kanal-MOS-Transistoren als auch mit p-Kanal-MOS-Transistoren realisierbar. Die Höhe der Nullfeldeinsatzspannung VTH0 der Transistoren spielt keine grundsätzliche Rolle. Ebenso ist es unerheblich, ob die Schaltungen in einem CMOS-n-Wannenprozeß, CMOS-p-Wannenprozeß, Dreiwannenprozeß oder ähnlicher Fertigungstechnik aufgebaut sind. Stromspiegelschaltungen können einfach oder aufwendig, beispielsweise mit Kaskode-Stufen ausgeführt sein. Alle gezeigten Transistoren können durch Kaskode-Stufen ergänzt sein mit dem Ziel, die Transistoreigenschaften zu verbessern.

Selbstverständlich können zur Bereitstellung einstellbarer Kanalweite und/oder -länge auch andere Anzahlen von Teiltransistoren als fünf vorgesehen sein.

Bezugszeichenliste

| 1 | Transistor |
|---|---|
| 2 | Steuereinheit |
| 3 | Verstärker |
| 4 | Komparator |
| 5 | Stromquelle |
| 6 | Stromquelle |
| 7 | Widerstand |
| 8 | Spannungsquelle |
| 9 | Bezugspotentialanschluß |
| 10 | Transistordiode |
| 11 | Transistor |
| 12 | Vorwiderstand |
| 13 | Lastwiderstand |
| 14 | Eingangsspannungsquelle |
| 15 | Temperatursensor |
| 16 | Referenzstromquelle |
| 17 | Stromausgang |
| 18 | Operationsverstärker |
| 19 | Bandgapquelle |
| 20 | Transistor |
| 21 | Widerstand |
| 24 | Spannungsquelle |
| 25 | Teiltransistor |
| 26 | Teiltransistor |
| 27 | Teiltransistor |
| 28 | Teiltransistor |
| 29 | Teiltransistor |
| 30 | Drain-Source-Anschluß |
| 31 | Schalter |
| 32 | Schalter |
| 33 | Schalter |
| 34 | Schalter |
| 35 | Schalter |
| 36 | Drain-Source-Anschluß |
| 37 | Schalttransistor |
| 38 | Schalttransistor |
| 39 | Schalttransistor |
| 40 | Schalttransistor |
| 41 | Schalttransistor |
| 42 | Inverter |
| 43 | Inverter |
| 44 | Inverter |
| 45 | Inverter |
| 46 | Inverter |
| 47 | Teiltransistor |
| 48 | Teiltransistor |
| 49 | Teiltransistor |
| 50 | Teiltransistor |
| 51 | Teiltransistor |
| 52 | Schalter |
| 53 | Schalter |
| 54 | Schalter |
| 55 | Schalter |
| 56 | Schalter |

57    Transistor
58    Transistor
59    Zuordnungstabelle

**Patentansprüche**

1.  Transistoranordnung mit Temperaturkompensation, aufweisend

    - zumindest einen Transistor (1) mit einem Steuereingang, mit einer gesteuerten Strecke und mit zumindest einem einstellbaren Geometrieparameter,
    - ein Mittel zur Temperaturmessung (15), ausgelegt zur Abgabe eines temperaturabhängigen Signals,
    - einen Vergleicher (4), der mit einer Steuereinheit (2) gekoppelt ist, mit Eingängen zur Zuführung eines temperaturunabhängigen Signals und zur Kopplung mit dem Mittel zur Temperaturmessung (8),
    - die Steuereinheit (2), die mit dem Transistor (1) gekoppelt ist zur Einstellung des zumindest einen Geometrieparameters des Transistors (1) in Abhängigkeit von dem Vergleichsergebnis.

2.  Transistoranordnung nach Anspruch 1,
    **dadurch gekennzeichnet, daß**
    der Transistor (1) ein unipolarer Transistor ist und daß der zumindest eine Geometrieparameter die Kanallänge und/oder die Kanalweite des Transistors umfaßt.

3.  Transistoranordnung nach Anspruch 2,
    **dadurch gekennzeichnet, daß**
    die Kanalweite und/oder die Kanallänge des Transistors **dadurch** (1) veränderbar ist, daß der Transistor mehrere parallel und/oder seriell verschaltete und in Abhängigkeit von dem temperaturabhängigen Signal einzeln zu- und abschaltbare Teiltransistoren (25, 26, 27, 28, 29; 47, 48, 49, 50, 51) umfaßt.

4.  Transistoranordnung nach einem der Ansprüche 1 bis 3,
    **dadurch gekennzeichnet, daß**
    zur Erzeugung des Temperatur-unabhängigen Signals eine Bandgap-Schaltung (18, 19, 20, 21, 5) vorgesehen und mittelbar oder unmittelbar an einen ersten Eingang des Vergleichers (4) angeschlossen ist.

5.  Transistoranordnung nach einem der Ansprüche 1 bis 4,
    **dadurch gekennzeichnet, daß**
    ein Regelkreis (2, 4, 10) vorgesehen ist, umfassend einen weiteren Transistor (10) mit zumindest einem einstellbaren Geometrieparameter, zu dessen Einstellung der weitere Transistor (10) mit der Steuereinheit (2) gekoppelt ist und der mit einem zweiten Eingang des Vergleichers (4) gekoppelt ist, wobei am ersten Eingang des Vergleichers (4) ein Mittel zum Zuführen eines Signals (7, 8) angeschlossen ist, das sich aus einem Teilwert einer Bandgap-Spannung und der Schwellspannung (VTHO) eines Transistors (8) zusammensetzt und als Führungsgröße für den Regelkreis (2, 4, 10) dient.

6.  Transistoranordnung nach einem der Ansprüche 1 bis 5,
    **dadurch gekennzeichnet, daß**
    eine Zuordnungstabelle (59) vorgesehen ist, die den Temperatursensor (15) mit der Steuereinheit (2) koppelt und die dem temperaturabhängigen Signal einen Korrekturwert zuordnet.

7.  Transistoranordnung nach einem der Ansprüche 1 bis 6,
    **dadurch gekennzeichnet, daß**
    das Mittel zur Temperaturmessung einen Transistor (10) umfaßt.

8.  Transistoranordnung nach einem der Ansprüche 1 bis 7,
    **dadurch gekennzeichnet, daß**

    - daß der zumindest eine Transistor (1) mehrere Teiltransistoren (25, 26, 27, 28, 29) umfaßt, die jeweils in einer Serienschaltung mit einem zugeordneten Schalttransistor (31, 32, 33, 34, 35) verschaltet sind,
    - daß die Serienschaltungen umfassend je einen Teiltransistor (25, 26, 27, 28, 29) und einen Schalttransistor (31, 32, 33, 34, 35) miteinander parallel verschaltet sind und

- daß die Schalttransistoren (31, 32, 33, 34, 35) je einen Steuereingang haben, die mit der Steuereinheit (2) gekoppelt sind.

**9.** Transistoranordnung nach Anspruch 8,
**dadurch gekennzeichnet, daß**
die Teiltransistoren (25, 26, 27, 28, 29) als Metall-Isolator-Halbleiter-Transistoren ausgebildet sind.

**10.** Transistoranordnung nach Anspruch 9,
**dadurch gekennzeichnet, daß**
am Drain-Anschluß der Teiltransistoren (25, 26, 27, 28, 29) jeweils der zugeordnete Schalttransistor (31, 32, 33, 34, 35) angeschlossen ist.

**11.** Transistoranordnung nach einem der Ansprüche 1 bis 10,
**dadurch gekennzeichnet, daß**
der zumindest eine Transistor (1) mehrere einzeln zu- und abschaltbare Teiltransistoren (25, 26, 27, 28, 29) umfaßt, denen jeweils eine Kaskode-Stufe (37, 38, 39, 40, 41) zugeordnet ist.

**12.** Verwendung einer Transistoranordnung nach einem der Ansprüche 1 bis 11
in einem integrierten Halbleiterschaltkreis.

**13.** Verfahren zur Temperaturkompensation eines Transistors mit folgenden Schritten:

- Messen der Temperatur und Bereitstellen eines temperaturabhängigen Signals,
- Vergleichen des temperaturabhängigen Signals mit einem temperaturunabhängigen Signal,
- Steuern zumindest eines einstellbaren Geometrieparameters zumindest eines Transistors (1) in Abhängigkeit von dem Vergleichsergebnis.

**14.** Verfahren nach Anspruch 13,
**dadurch gekennzeichnet, daß**
in Abhängigkeit von dem Vergleichsergebnis die Kanalweite des Transistors (1) eingestellt wird.

**15.** Verfahren nach Anspruch 13 oder 14,
**dadurch gekennzeichnet, daß**
in Abhängigkeit von dem Vergleichsergebnis die Kanallänge des Transistors (1) eingestellt wird.

**16.** Verfahren nach Anspruch 14 oder 15,
**dadurch gekennzeichnet, daß**
das Einstellen der Kanallänge und/oder der Kanalweite des Transistors (1) durch jeweiliges Zu- und Abschalten mehrerer, parallel und/oder seriell verschalteter Teiltransistoren (25, 26, 27, 28, 29; 47, 48, 49, 50, 51) erfolgt.

**Claims**

**1.** Transistor arrangement with temperature compensation, having

- at least one transistor (1) having a control input, having a controlled path and having at least one adjustable geometric parameter,
- a temperature measuring means (15), designed for outputting a temperature-dependent signal,
- a comparator, (4), coupled to a control unit (2), having inputs for feeding in a temperature-independent signal and for coupling to the temperature measuring means (8),
- the control unit (2), coupled to the transistor (1) for the purpose of setting the at least one geometric parameter of the transistor (1) in a manner dependent on the comparison result.

**2.** Transistor arrangement according to Claim 1,
**characterized in that**
the transistor (1) is a unipolar transistor, and the at least one geometric parameter comprises the channel length and/or the channel width of the transistor.

**3.** Transistor arrangement according to Claim 2,
**characterized in that**
the channel width and/or the channel length of the transistor (1) is variable by virtue of the fact that the transistor comprises a plurality of partial transistors (25, 26, 27, 28, 29; 47, 48, 49, 50, 51) that are connected up in parallel and/or in series and can be individually switched in and out in a manner dependent on the temperature-dependent signal.

**4.** Transistor arrangement according to one of Claims 1 to 3,
**characterized in that**
in order to generate the temperature-independent signal, a bandgap circuit (18, 19, 20, 21, 5) is provided and is connected indirectly or directly to a first input of the comparator (4).

**5.** Transistor arrangement according to one of Claims 1 to 4,
**characterized in that**
a control loop is provided, comprising a further transistor (10) having at least one adjustable geometric parameter, for the setting of which the further transistor (10) is coupled to the control unit (2), and which is coupled to a second input of the comparator (4), a means for feeding in a signal (7, 8) which is composed of a partial value of a bandgap voltage and the threshold voltage (VTH0) of a transistor (8) and serves as reference variable for the control loop (2, 4, 10).

**6.** Transistor arrangement according to one of Claims 1 to 5,
**characterized in that**
an assignment table (59) is provided, which couples the temperature sensor (15) to the control unit (2) and which assigns a correction value to the temperature-dependent signal.

**7.** Transistor arrangement according to one of Claims 1 to 6,
**characterized in that**
the temperature measuring means comprises a transistor (10).

**8.** Transistor arrangement according to one of Claims 1 to 7,
**characterized in that**

- the at least one transistor (1) comprises a plurality of partial transistors (25, 26, 27, 28, 29) which are in each case connected up in a series circuit with an assigned switching transistor (31, 32, 33, 34, 35),
- the series circuits each comprising a partial transistor (25, 26, 27, 28, 29) and a switching transistor (31, 32, 33, 34, 35) are connected up in parallel with one another, and
- the switching transistors (31, 32, 33, 34, 35) each have a control input, which are coupled to the control unit (2).

**9.** Transistor arrangement according to Claim 8,
**characterized in that**
the partial transistors (25, 26, 27, 28, 29) are embodied as metal insulator semiconductor transistors.

**10.** Transistor arrangement according to Claim 9,
**characterized in that**
the assigned switching transistor (31, 32, 33, 34, 35) is in each case connected to the drain terminal of the partial transistors (25, 26, 27, 28, 29).

**11.** Transistor arrangement according to one of Claims 1 to 10,
**characterized in that**
the at least one transistor (1) comprises a plurality of partial transistors (25, 26, 27, 28, 29) that can be individually switched in and out and which are in each assigned a cascode stage (37, 38, 39, 40, 41).

**12.** Use of a transistor arrangement according to one of Claims 1 to 11,
in an integrated semiconductor circuit.

**13.** Method for the temperature compensation of a transistor comprising the following steps:

- measuring the temperature and providing a temperature-dependent signal,

- comparing the temperature-dependent signal with a temperature-independent signal,
- controlling at least one adjustable geometric parameter of at least one transistor (1) in a manner dependent on the comparison result.

**14.** Method according to Claim 13,
**characterized in that**
the channel width of the transistor (1) is set in a manner dependent on the comparison result.

**15.** Method according to Claim 13 or 14,
**characterized in that**
the channel length of the transistor (1) is set in a manner dependent on the comparison result.

**16.** Method according to Claim 14 or 15,
**characterized in that**
the channel length and/or the channel width of the transistor (1) is set by respectively switching in and out a plurality of partial transistors (25, 26, 27, 28, 29; 47, 48, 49, 50, 51) connected up in parallel and/or in series.

**Revendications**

**1.** Montage à transistor à compensation de température, comportant

- au moins un transistor (1) ayant une entrée de commande, une section commandée et au moins un paramètre géométrique réglable,
- un moyen de mesure (15) de la température, conçu pour émettre un signal qui dépend de la température,
- un comparateur (4) qui est couplé à l'unité (2) de commande et qui a des entrées d'envoi d'un signal indépendant de la température et de couplage au moyen de mesure (8) de la température,
- l'unité (2) de commande, qui est couplée au transistor (1) pour le réglage du au moins un paramètre géométrique du transistor (1) en fonction du résultat de la comparaison.

**2.** Montage à transistor suivant la revendication 1,
**caractérisé en ce que**
le transistor (1) est un transistor unipolaire et **en ce que** le au moins un paramètre géométrique comprend la longueur de canal et/ou la largeur de canal du transistor.

**3.** Montage à transistor suivant la revendication 2,
**caractérisée en ce que**
la largeur de canal et/ou la longueur de canal du transistor peuvent être modifiées par le fait (1) que le transistor comprend plusieurs sous-transistors (25, 26, 27, 28, 29; 47, 48, 49, 50, 51) montés en parallèle et/ou en série, pouvant être mis individuellement à l'état passant et à l'état bloqué en fonction du signal qui dépend de la température.

**4.** Montage à transistor suivant l'une des revendications 1 à 3,
**caractérisé en ce que** la production du signal indépendant de la température, un circuit (18, 19, 20, 21, 5) à bande interdite est prévu et est raccordé directement ou indirectement à une première entrée du comparateur (4).

**5.** Montage à transistor suivant l'une des revendications 1 à 4,
**caractérisé en ce qu'**il est prévu un circuit (2, 4, 10) de régulation, comprenant un autre transistor (10) ayant au moins un paramètre géométrique réglable, pour le réglage duquel l'autre transistor (10) est couplé à l'unité (10) de commande et qui est couplé à une deuxième entrée du comparateur (4) dans lequel il est raccordé à la première entrée du comparateur (4) un moyen d'envoi d'un signal (7, 8) qui se compose d'une valeur partielle d'une tension de bande interdite et de la tension (VTHO) de seuil d'un transistor (8) et qui sert de grandeur de guidage pour le circuit (2, 4, 10) de régulation.

**6.** Montage à transistor suivant l'une des revendications 1 à 5,
**caractérisé en ce qu'**il est prévu une table (59) d'association, qui couple le capteur (15) de température à l'unité (2) de commande et qui associe une valeur de correction au signal en fonction de la température.

**7.** Montage à transistor suivant l'une des revendications 1 à 6,

**caractérisé en ce** le moyen de mesure de la température comprend un transistor (10).

8. Montage à transistor suivant l'une des revendications 1 à 7,
   **caractérisé en ce que**

   - au moins un transistor (1) comprend plusieurs sous transistors (25, 26, 27, 28, 29) qui sont montés respectivement dans un circuit série avec un transistor (31, 32, 33, 34, 35) de commutation associé,
   - les circuits série comprenant respectivement un sous transistor (25, 26, 27, 28, 29) et un transistor (31, 32, 33, 34, 35) de commutation sont montés en parallèle entre eux et
   - les transistors (31, 32, 33, 34, 35) de commutation ont respectivement une entrée de commande, qui est couplée à l'unité (2) de commande .

9. Montage à transistor suivant la revendication 8,
   **caractérisé en ce que** les sous-transistors (25, 26, 27, 28, 29) sont constitués sous la forme de transistors métal-isolant-semi-conducteur.

10. Montage à transistor suivant la revendication 9,
    **caractérisé en ce que** la borne de drain des sous-transistors (25, 26, 27, 28, 29) est raccordée respectivement au transistor (31, 32, 33, 34, 35) de commutation associé.

11. Montage à transistor suivant l'une des revendications 1 à 10,
    **caractérisé en ce que** le au moins un transistor (1) comprend plusieurs sous-transistors (25, 26, 27, 28, 29) pouvant être mis individuellement à l'état passant et bloqués et auquel est associé respectivement un étage (37, 38, 39, 40, 41) cascode.

12. Utilisation d'un montage à transistor selon l'une des revendications 1 à 11, dans un circuit intégré à semiconducteur.

13. Procédé de compensation en température d'un transistor ayant les stades suivants :

    - on mesure la température et on met à disposition un signal qui dépend de la température,
    - on compare le signal qui dépend de la température à un signal indépendant de la température,
    - on commande au moins un paramètre géométrique réglable du au moins un transistor (1) en fonction du résultat de la comparaison.

14. Procédé suivant la revendication 13,
    **caractérisé en ce que**
    on règle la largeur de canal du transistor (1) en fonction du résultat de la comparaison.

15. Procédé suivant la revendication 13 ou 14,
    **caractérisé en ce que**
    on règle la longueur du canal du transistor (1) en fonction du résultat de la comparaison.

16. Procédé suivant la revendication 14 ou 15, **caractérisé en ce que**
    on effectue le réglage de la longueur du canal et/ou de la largeur du canal du transistor (1) par respectivement plusieurs sous transistors (25, 26, 27, 28, 29, 47, 48, 49, 50, 51) montés en parallèle et/ou en série, respectivement à l'état passant et à l'état bloqué.

## FIG 1

## FIG 2

## FIG 3

+VDD

System
Temperatur

System
Temperatur

Temperatur
Sensor  15

n-Bit

W-Control  2

Clock

Adjust

i-Bit

12

I_out

17

D    gm    D

G    1    11    G

S    S

14

2·Iref

16

GND  9

## FIG 4

18

+VDD    +VDD    +VDD

20    5    6

Iref0    Iref1    Iref2

K1    K2

V_BG

19

R0  V_BG'

21

RI  Vx

7

Vth0

24

G    D

10    S

V_BG

GND  9    GND  9    GND  9    GND  9

FIG 5A

FIG 5B

## FIG 6

## FIG 7

## FIG 8

# FIG 9

FIG 10

Drain
Source

52
47

53
48

54
49

55
50

56
51

Gate

Source
Drain

L-Control

i

Drain
Source

Gate

Source
Drain

i

L-Control

FIG 11

57
GND

58
GND

## FIG 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6674377 B1